# EUROPEAN PATENT APPLICATION

(11) **EP 2 009 823 A1**
(43) Date of publication of application: **31.12.2008**
(21) Application number: 08011585.0
(22) Date of filing: 26.06.2008
(51) Int. Cl.: H04J 3/16, H04L 1/00

(54) **Communication apparatus communicating with different bit rates**

(30) Priority: 29.06.2007 JP 2007173189
(71) Applicant: FUJITSU LIMITED, Kawasaki-shi, Kanagawa 211-8588 (JP)
(72) Inventor: Sakai, Yoshio, Kawasaki-shi Kanagawa 211-8588 (JP); Mori, Kazuyuki, Kawasaki-shi Kanagawa 211-8588 (JP)
(74) Representative: HOFFMANN EITLE

(57) **Abstract**

In order to allow bit-interleaved-parity calculation to be easily performed while maintaining compatibility with an existing system during transmission of data having mixed bit rates, header information of a first bit rate is added to data of the first bit rate and data of a second bit rate, time-division multiplexing is performed on the header-information-added data signals to generate a data string and a frame header is added thereto to generate a frame signal, parities of the frame signal that is sequentially generated are determined, parity bits for parity checking for the data signals of the first bit rate and the data signals of the second bit rate are inserted into the frame signal, based on a result of the parity calculation.

## Description

### TECHNICAL FIELD

It relates to a parity-bit inserting method, a parity checking method, and a communication apparatus (a station-side apparatus: an apparatus set up in a station), and a terminal device (a subscriber device) which is preferably used for, for example, a system that uses a passive optical network (PON).

A system in which an optical station-side apparatus provided at a central exchange installed at a telephone station or the like and optical subscriber devices provided at subscribers' homes are connected through optical fibers is known as a subscriber optical fiber network system intended for ordinary households. An architecture in which a power splitter, which is a passive device, is used to branch an optical fiber for inputting/outputting optical data signals to/from the central exchange to connect optical network units of subscribers' homes at the branched ends is called a PON system.

The PON system has been put to practical use as a system that allows high-speed data transmission/reception to be performed between the optical station-side apparatus and the subscribers' homes.

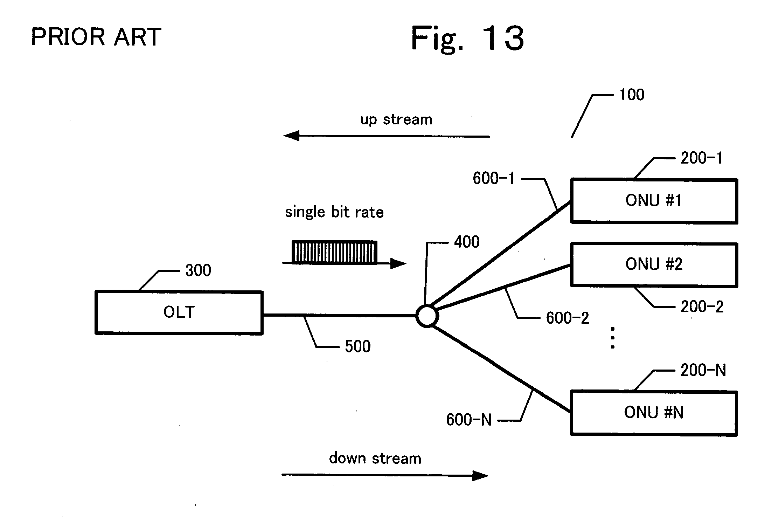

As one example of a communication network using such a PON system, a system having a configuration as shown in Fig. 13 is known.

A PON system 100 shown in Fig. 13 includes a station-side apparatus (optical line terminal (OLT)) 300, N optical subscriber devices (i.e., optical network units (ONUs)) 200-1 to 200-N (simply referred to as an "ONU 200" when not distinguished) corresponding to N subscribers #1 to #N (N is an integer of 2 or more), a power splitter 400, an optical fiber 500 that connects the OLT 300 and the power splitter 400, and optical fibers 600-1 to 600-N (simply referred to as an "optical fiber 600" when not distinguished) that connect the power splitter 400 and the corresponding ONU 200-1 to 200-N.

The OLT 300 in the PON system 100 serves as an apparatus having a communication control function. That is, for example, the OLT 300 converts electrical signals into optical signals to perform information distribution or the like and transmits the optical signals to the ONU 200 in a predetermined downstream frame format, and also receives optical signals having a predetermined upstream frame format from the ONUs 200 and converts the optical signals into electrical signals.

The power splitter 400 is provided at midstream of a transmission path to branch the optical fiber 500 connected to the OLT 300, and the branched optical fibers 600 are installed into the subscribers' homes and are connected to the ONUs 200.

The ONU 200 serves as a device for performing communication and control, such as communication with the OLT 300 and conversion between optical signals and electrical signals.

In this case, the single optical fiber 500 is used to perform bidirectional data transmission, i.e., upstream and downstream data transmission, between the OLT 300 and the power splitter 400 through wavelength division multiplexing (WDM). In the description below, the direction from the OLT 300 to the ONU 200 is downstream and the direction from the ONU 200 to the OLT 300 is upstream.

For example, downstream signals are transmitted from the OLT 300 to the ONU 200 as optical signals in a 1.49 µm band at a single bit rate A through time division multiplexing (TDM). The ONU 200 detects frame-synchronization information and management information contained in the downstream signals. Based on the detected information, the ONU 200 extracts data in an individually pre-assigned timeslot. On the other hand, upstream signals are transmitted from the ONU 200 to the OLT 300 at timing specified by the OLT 300. More specifically, upstream signals are transmitted from the ONU 200 as optical signals in a 1.31 µm band through time division multiple access (TDMA) at timing at which the upstream signals do not conflict with the downstream signals.

The power splitter 400 serves to distribute (power-split) downstream signals from one optical fiber 500 to the multiple optical fibers 600 and to aggregate (multiplex) upstream signals from the optical fibers 600 into one optical fiber 500.

Conventionally, the PON system 100 has been typically contemplated to provide a low-speed service for telephones, but in recent years, there have been increasing demands for high-speed communication services, such as videophone services and videoconferencing services that use higher speeds than the telephone services. Thus, it is necessary to provide low-bit-rate data (for low-speed services, such as telephones) and high-bit-rate data (for high-speed services, such as videophone services and videoconferencing services) by using one PON system 100.

For example, Japanese Laid-open Patent Publication No. 8-8954 discloses a system for increasing a service capacity in a point-to-multipoint optical transmission system through the use of multi-rate burst circuits for generating signals that have a different speed for each time slot. In the technology, in order to provide low-bit-rate data and high-bit-rate data by using one PON system, multi-rate burst circuits are provided in all ONUs 200 and signals of a different transmission speed (bit rate) are allotted to one of timeslots assigned to one ONU 200. With this arrangement, the system is applicable to not only low-speed services but also high-speed services.

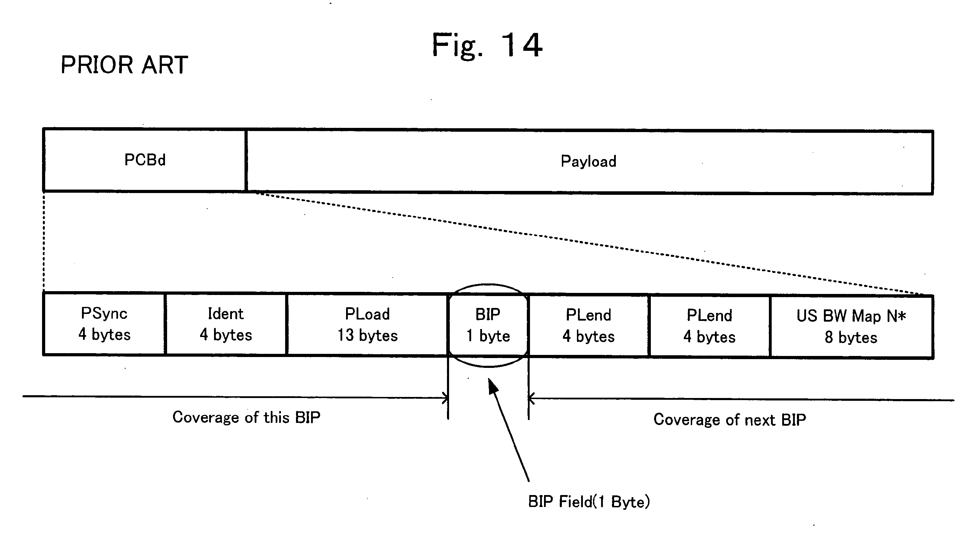

For a standardized communication system, such as a PON (passive optical network), SONET/SDH (synchronous optical network/synchronous digital hierarchy), for example, for a G-PON frame structure standardized by ITU-T (International Telecommunication Union Telecommunication Standardization Sector), ITU-T Rec.G.984.3 defines BIP (bit interleaved parity) fields for monitoring a communication-line state, for example, as shown in Fig. 14.

In Fig. 14, the BIP field has a 1-byte parity check bit and is contained in a PCBd (Physical Control Block downstream) field, in a data structure in which data signals having a single bit rate are time-division multiplexed in a payload portion of a frame signal that is sequentially transmitted as a data stream. The PCBd field serves as a header portion that precedes the payload portion in the frame signal. In the PCBd field, a PSync field to which synchronization information is written, an Ident field, a PLOAMd field, the BIP field, PLend fields, and a US BW Map field are arranged sequentially from the front-end of the frame signal.

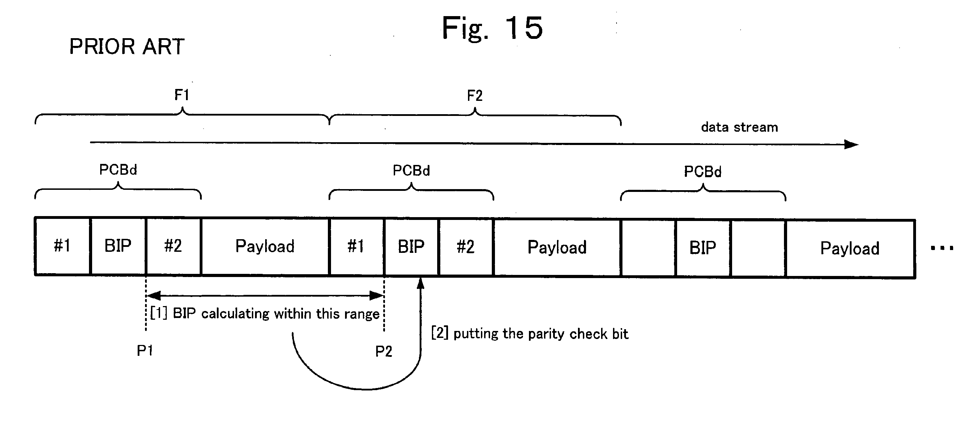

As shown in Fig. 15, parity calculation is performed on a bit string in an area between a position P1 (located at the end of a BIP field in a preceding frame signal F1 that is previously input) and a position P2 (located immediately before a BIP field in a current frame signal F2), i.e., an area including a PCBd #2 field and a payload in the preceding frame signal F1 and a PCBd #1 field in the current frame signal F2 (see [1] in Fig. 15), and a parity check bit resulting from the parity calculation is inserted into a BIP field in the current frame signal F2 (see [2] in Fig. 15). The PCBd #1 field shown in Fig. 15 corresponds to the PSync field, the Ident field, and the PLOAMd field in Fig. 14, and the PCBd #2 field corresponds to the PLend fields and the US BW Map field.

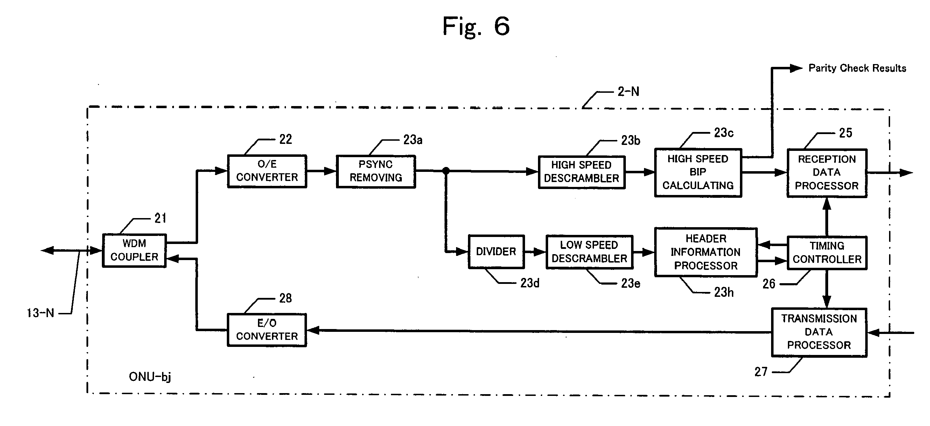

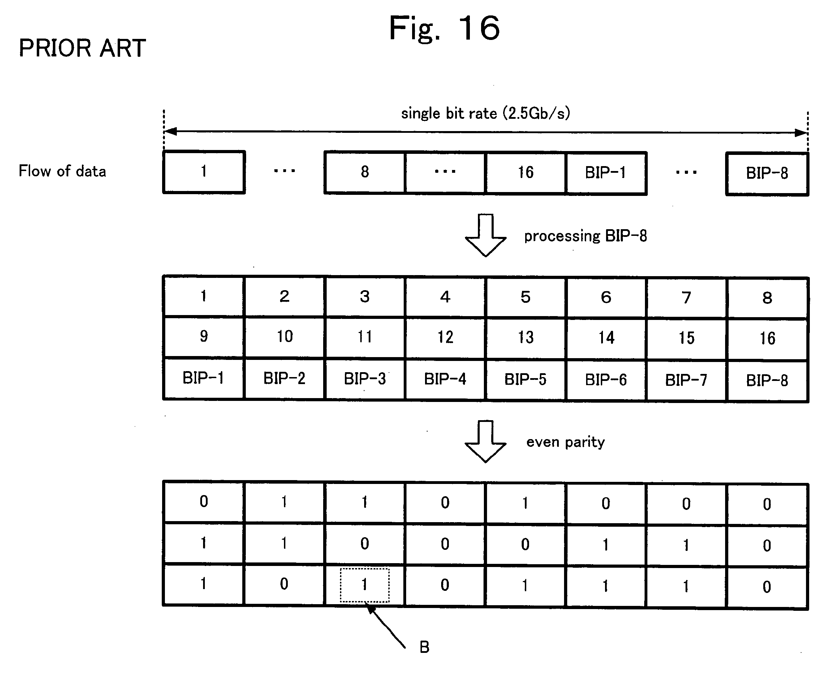

More specifically, bits are arranged for every 8 bits from the position P1 in the above-described frame signal F1. As shown in Fig. 16, when bits are arranged in eight columns in the vertical direction, parity bits are inserted bit by bit so that the parity in each column has even-number parity, i.e., the number of bit values "1" in each column is an even umber. For example, the 3rd column from the left in Fig. 16 contains the 3rd and 11th bits in data positions. In this case, when the values of the bits have logic level "1" and "0" as shown in Fig. 16, "1" inserted as a parity bit BIP-3 (see B in Fig. 6).

Fig. 16 illustrates a case in which 1st to 16th bits, each having the same bit rate (e.g., 2.5 G/s) for simplicity of description, are arranged and 8-bit bits BIP-1 to BIP-8 are arranged subsequent to the 16th bit. The values of the 1st to 16th bits shown in Fig. 16 are merely examples. Other related technologies include Japanese Laid-open Patent Publication Nos. 2000-188593 and 9-214541 which are described below.

However, known systems, for example, a G-PON (Gigabit-capable Passive Optical Network) standardized by ITU-T do not employ a scheme in which a bit rate is varied for each service to perform transmission in a physical layer. Thus, the method disclosed in Japanese Laid-open Patent Publication No. 8-8954 needs some improvement in compatibility with the known systems.

Since the technology disclosed in Publication No. 8-8954 also requires preparing (installing) multi-rate burst circuits in all ONUs 200, even a subscriber who does not desire a high-speed service also needs to upgrade the ONU (e.g., by installing the multi-rate burst circuit). Thus, the technology has problems in that the device upgrading is complicated and cost is required therefor.

As described above, when data having a low bit rate and data having a high bit rate are to be supplied in one communication system, as described above, there is a problem in that it is difficult to perform the above-described BIP calculation with a scheme defined by ITU-T G.984.3.

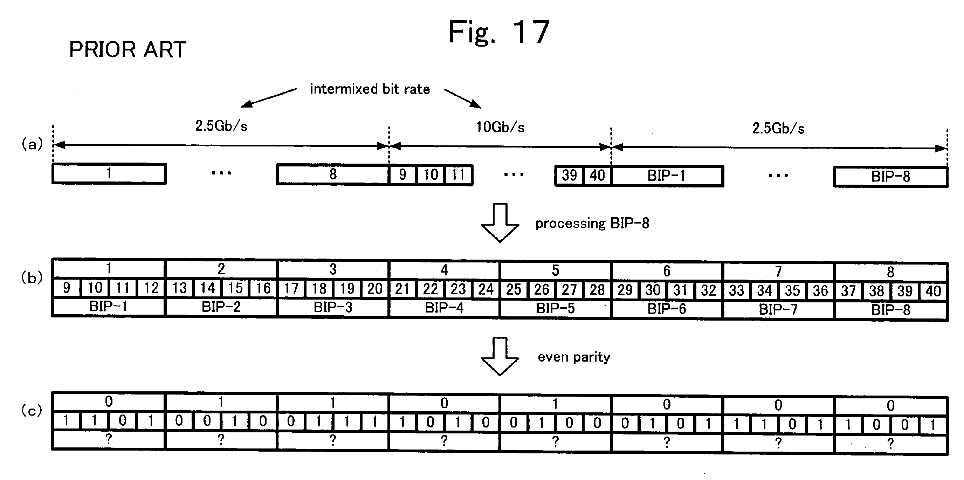

That is, as shown in part (a) in Fig. 17, it is now assumed that bit rates of a data stream are mixed, i.e., a flow of data having a bit rate of 2.5 Gb/s (i.e., the 1st to 8th bits) is followed by a flow of data having a bit rate of 10 Gb/s (i.e., the 9th to 40th bits). In this case, parity bits to be inserted into BIP fields that follow the data stream will now be discussed.

When parity calculation is to be performed using a scheme that complies with G.984.3, the parity bits need to have a bit rate that matches an existing low-speed ONU so that the parity bits can be processed by the low-speed ONU. Thus, in the case of a data stream as shown in part (a) in Fig. 17, the bit rate of the BIP fields inserted by the OLT needs to be the low-speed bit-rate "2.5 Gb/s".

In this case, as shown in part (b) in Fig. 17, since the unit bit length of 2.5 Gb/s is four times the unit bit length of 10 Gb/s, each of eight 2.5 Gb/s bits is followed by four 10 Gb/s bits to form a column for parity calculation. For example, the 1st 2.5 Gb/s bit is followed by the 9th to 12th 10 Gb/s bits to form a column for parity calculation.

In this case, when parity in each column is to be calculated, it is difficult to determine a reliable and accurate parity bit, as shown in part (c) in Fig. 17, since four 10 Gb/s bits arranged in the unit bit time of 2.5 Gb/s. That is, in part (c) in Fig. 17, the logic level "0" or "1" cannot be uniquely set in each BIP filed. If the BIP field has a bit length of 10 Gb/s, the value can be set. With such an arrangement, however, the ONU for receiving 2.5 Gb/s data cannot perform BIP processing, and if an attempt is made to perform BIP processing, the device configuration requires a considerable improvement.

As a structure example of a frame signal transmitted from a transmission apparatus that serves as an OLT in a PON, Japanese Laid-open Patent Publication No. 2000-188593 discloses a frame signal in which sub-frames having different speeds are multiplexed. The technology, however, does not describe performing BIP computation on an overhead serving as a frame header.

Japanese Laid-open Patent Publication No. 9-214541 discloses a technology in which multiple' framer functions are provided in an OLT in association with corresponding ONUs to allow the OLT and each ONU to perform point-to-point communication using an independent optical fiber. The technology, however, is not intended to achieve BIP calculation for a mixed-bit-rate frame. The technology also requires changes in the hardware level of the OLT and also requires changes in a communication-line facility, which consequently involves large scales changes in the network configuration.

### SUMMARY

It is an object to allow BIP calculation to be easily performed when data having different bit rates are to be transmitted in a mixed manner, while maintaining compatibility with an existing system.

Another object is to provide advantages that are offered by the configurations described in the best mode for implementing the present invention and that cannot be obtained by the known technologies.

According to an aspect of an embodiment, a communication apparatus for performing optical communication with a first terminal device communicating at a first bit rate, and a second terminal device communicating at a second bit rate being a multiple of the first bit rate, via an optical splitting device, the communication apparatus comprising: a transmission-data processing unit for processing a bit rate of data signals transmitted to the second terminal device so as to be a multiple of the bit rate of data signals transmitted to the first terminal device, the data signals being contained in a frame signal transmitted from the communication apparatus; and a parity-bit inserting unit for inserting, into the frame signal, each parity-bits for parity checking for the data signals transmitted to the first terminal device, and the second terminal device respectively.

As described above, the embodiment provides advantages in that when data having mixed bit rates are to be transmitted, BIP calculation can be easily performed while maintaining compatibility with an existing system and reducing cost and work required for upgrading the optical subscriber devices.

### BRIEF DESCRIPTION OF THE DRAWINGS

Fig. 1 is a block diagram showing the configuration of a major section of a PON system according to a first embodiment;
Fig. 2 illustrates the format of downstream frame signals from an OLT to ONUs in the first embodiment;
Fig. 3 is a block diagram showing the configuration of a major section of the OLT in the first embodiment;
Fig. 4 illustrates one example of a parity calculation scheme for a BIP calculating unit in the first embodiment;
Fig. 5 is block diagram showing the ONU in the first embodiment;
Fig. 6 is a block diagram showing the ONU in the first embodiment;
Fig. 7 is a block diagram showing the configuration of a major section of an OLT in a second embodiment;
Fig. 8 illustrates one example of a parity calculation scheme for a BIP calculating unit in the second embodiment;
Fig. 9 is block diagram showing an ONU in the second embodiment;
Fig. 10 is a block diagram showing the configuration of a major section of an OLT in a third embodiment;
Fig. 11 illustrates one example of a parity calculation scheme for a BIP calculating unit in the third embodiment;
Fig. 12 is block diagram showing an ONU in the third embodiment;
Fig. 13 shows one configuration of a communication network using a PON system;
Fig. 14 shows a BIP field, inserted in a frame header, for monitoring a communication-line state;
Fig. 15 illustrates a BIP calculation scheme;
Fig. 16 illustrates a BIP calculation scheme; and
Fig. 17 illustrates a problem to be solved.

### DESCRIPTION OF THE PREFERRED EMBODIMENTS

Embodiments will now be described below with reference to the accompanying drawings.

The present invention is not limited to the embodiments described below. The above-described and other objects, technical problems, means for solving the technical problems, and advantages will become apparent from the disclosure of the embodiments described below.

### A) First Embodiment

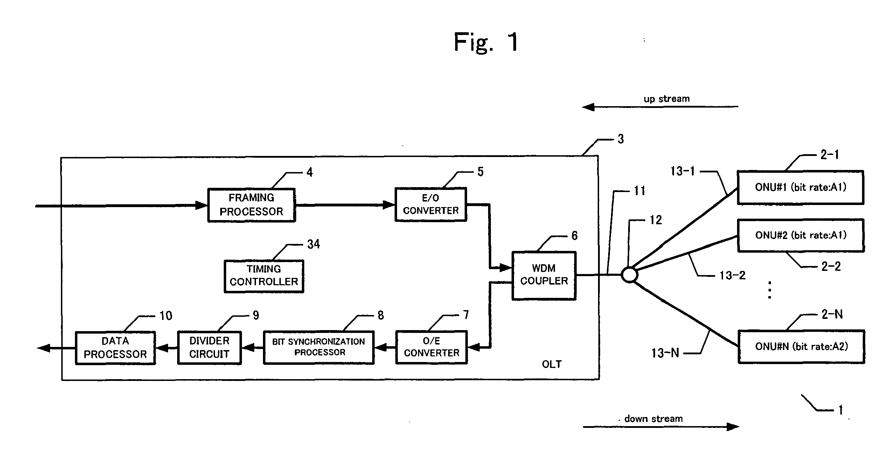

Fig. 1 shows the configuration of a major section of a passive optical network (PON) system according to a first embodiment. A PON system 1 shown in Fig. 1 includes an optical station-side apparatus 3 (hereinafter referred to as an "OLT (optical line terminal)") serving as a communication apparatus, N optical subscriber devices (hereinafter referred to as "ONUs (optical network units)") 2-1 to 2-N (simply expressed as an "ONU 2" when not distinguished) serving as terminal devices corresponding to subscribers #1 to #N (N is an integer of 2 or more), a wavelength-division multiplexing coupler 12, an optical fiber 11 that connects the OLT 3 and the wavelength-division multiplexing coupler 12, and optical fibers 13-1 to 13-N (simply expressed as an "optical fiber 13" when not distinguished) that are connected to the ONUs 2-1 to 2-N.

The wavelength-division multiplexing coupler 12 and the optical fibers 11 and 13-1 to 13-N constitute a transmission path through which an optical signal from the OLT 3 is split and the split optical signals are connected to the ONUs 2 serving as first and second subscriber devices. For each ONU 2, a basic bit rate (hereinafter referred to as a "first bit rate ") A1 or another bit rate (hereinafter referred to as a "second bit rate ") A2 is set as a transmission bit rate to receive data signals from the OLT 3. Data signal having the set communication bit rate are transmitted to/received from the OLT 3. The second bit rate A2 is M times the first bit rate A1 (M is an integer of 2 or more, and M=4 in the present embodiment).

That is, in the present embodiment, the first bit rate A1 is 2.5 Gb/s and the second bit rate A2 is 10 Gb/s, which corresponds to four times the first bit rate A1. That is, the bit rate of 2.5 Gb/s or the bit rate of 10 Gb/s can be used for each ONU 2 to receive data signals.

With this arrangement, in the PON system 1 for transmitting/receiving data signals at the first bit rate, making simple changes to the configuration of the ONUs and the OLT for transmitting/receiving data signals at the second bit rate allows optical signals of mixed bit rates to be transmitted/received for users who wish to transmit/receive data signals of the second bit rate without making any change to the existing basic configuration of the ONUs for transmitting/receiving data signals of the first bit rate.

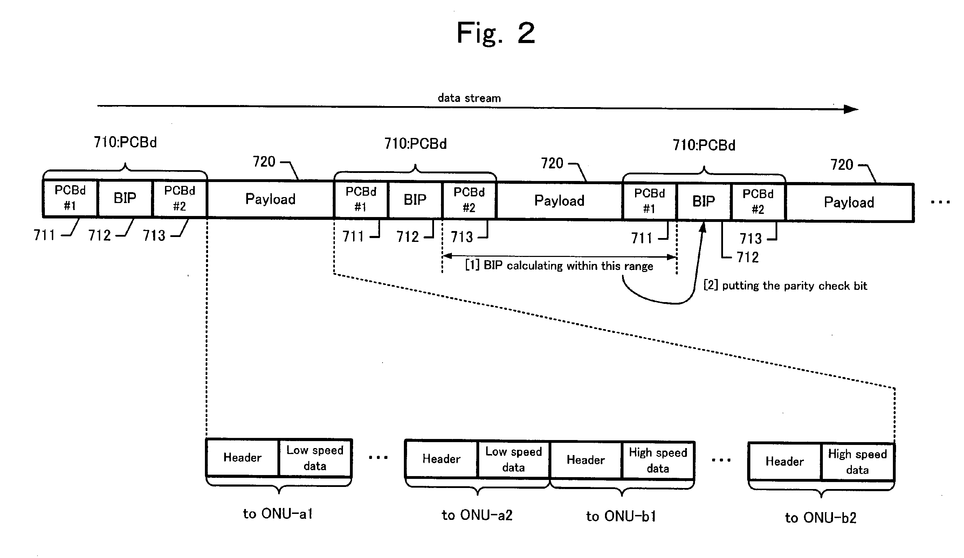

In this case, the OLT 3 transmits, to the ONU 2, optical frame signals that have, for example, a frame format as shown in Fig. 2 and that contain time-division-multiplexed data packets having mixed bit rates, to thereby achieve time division multiple access with the ONU 2. At individual transmission timing specified by the OLT 3, each ONU 2 transmits data packets of a bit rate set by the ONU 2, to thereby achieve time-division multiple access with the OLT 3.

For example, as shown in Fig. 1, the ONUs 2-1 to 2-(N-1)(which correspond to the subscribers #1 to #N-1) can be configured as ONUs (may hereinafter be referred to as "first subscriber devices" or "first terminal devices") dedicated to perform reception processing for low-speed data of 2.5 Gb/s, which is the first bit rate, and the ONU 2-N (which corresponds to the subscriber #N) can be configured as an ONU (may hereinafter be referred to as a "second subscriber device" or "second terminal device") that is capable of performing reception processing for high-speed data of a bit rate B that is four times the bit rate A1. The ONUs that serve as the first subscriber devices and the ONU that serves as the second subscriber devices may hereinafter be expressed as "ONU-ai" and "ONU-bj", respectively (i and j are natural numbers given for the low-speed ONU and the high-speed ONU, respectively).

The ONU 2 in the present embodiment has a configuration in which the bit rate of a downstream data packet from the OLT 3 and the bit rate of an upstream data packet to the OLT 3 are the same, but may be different from each other.

The frame signal shown in Fig. 2 has a PCBd (Physical Control Block downstream) field 710 for a frame header and a payload field 720 subsequent to the PCBd field 710. Frame signals having such a frame format are continuously transmitted from the OLT 3 as a data stream. The PCBd field 710 includes a PCBd #1 field 711 containing synchronization information and described in the background of the invention, a BIP field 712, and a PCBd #2 field 713.

In the first embodiment, not only parity bits for parity to be checking performed by the ONUs for receiving low-speed data, i.e., data of the first bit rate A1, (see the ONU-a1 and ONU-a2 in Fig. 2 and the ONUs 2-1 to 2-(N-1) in Fig. 1) but also parity bits for parity checking performed by the ONUs for receiving high-speed data, i.e., data with the second bit rate A2, (see the ONU-b1 and ONU-b2 in Fig. 2 and the ONU 2-N in Fig. 1) are written to the BIP field 712.

Data signals addressed to each ONU 2 are time-division multiplexed, as a data packet, in the payload field 720. The data packet is generated with individual header information (header) being inserted in the beginning portion of a data field included in the data signal addressed to each ONU 2. The individual header information contains management information, such as information regarding a destination ONU of data written to the subsequent data field and information regarding a data-signal bit rate processed by the destination ONU.

As shown in Fig. 1, the OLT 3 includes, for example, a framing processor 4, an electro/optical (E/O) converter 5, a wavelength division multiplexing (WDM) coupler 6, an optical/electro (O/E) converter 7, a bit synchronization processor 8, an M divider circuit 9, a data processor 10, and a timing controller 34.

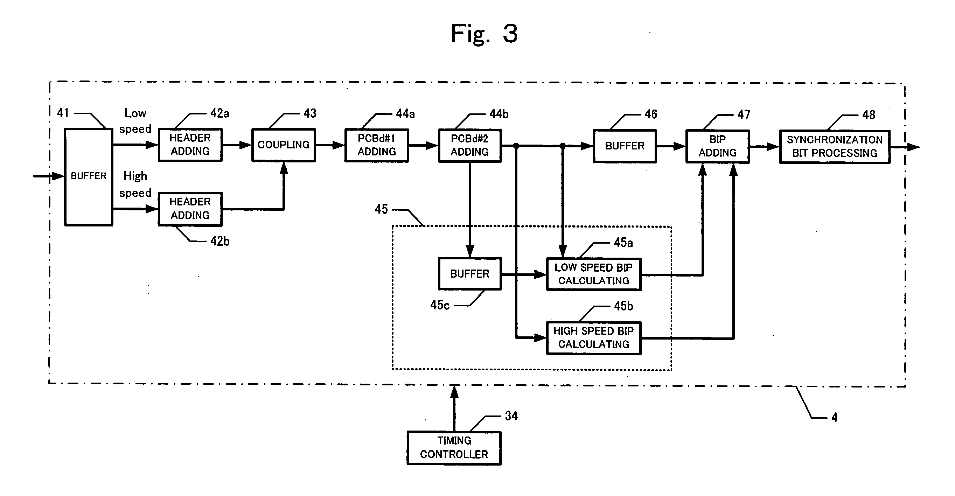

The framing processor 4 has a configuration as described below and shown in Fig. 3, and generates a frame signal by framing (time-division multiplexing), in the format shown in Fig. 2, downstream data to be transmitted (broadcast) to the ONUs 2.

The timing controller 34 has a function for managing a sequence or arrangement timing of time-division multiplexing data signals in the payload field 720 contained in the frame signal in association with a destination ONU 2 and also has a function for managing reception timing of signals transmitted from the ONU 2 and for controlling an ON/OFF operation of the M divider circuit 9 (described below) based on the reception timing.

The E/O converter 5 electro-optically converts the downstream signals, generated by the framing processor 4, from electrical signals into optical signals (e.g., light in a 1.49 µm band). The WDM coupler 6 transmits the downstream signals, electro-optically converted by the E/O converter 5, to the optical fiber 11 and also branches upstream signals (e.g., light in a 1.31 µm band), transmitted from the optical fiber, to the O/E converter 7.

The O/E converter 7 opto-electrically converts the upstream signals, branched by the WDM coupler 6, from the optical signals into electrical signals. The bit synchronization processor 8 performs reception processing on the upstream signals from the ONU 2 at a clock frequency (hereinafter referred to as a "clock A2") corresponding to the second bit rate A2 and bit-synchronizes the reception timing of data contained in the upstream signals and the reception-processing operation clock of the OLT 3.

The M divider circuit 9 divides the frequency of the reception processing operation clock of the OLT 3 by M (which is an integer of 2 or more). For example, the timing controller 34 turns on the M divider circuit 9 at timing at which the data of the bit rate A1 "2.5 Gb/s" is received, to divide the frequency of 10 GHz, which is the reception operation clock A2 of the OLT 3, by M (=4). The data processor 10 performs reception processing at a four bit cycle (at a rate once in every four clocks) of the clock A2 of the data of the bit rate A1.

Since the bit rate A2 is M times the bit rate A1 (M = 4 in this case), the clock A2 is also M times a clock frequency corresponding to the bit rate A1 (this clock frequency will hereinafter be referred to as "clock A1"). Thus, the M divider circuit 9 is controlled to be turned on, so that the data processor 10 operates at the clock A1, which is obtained by frequency-dividing the clock A2 by M, with respect to the data of the bit rate A1.

On the other hand, at timing at which the data of the bit rate A2 is received, the timing controller 34 turns off the operation of the M divider circuit 9. Thus, the data processor 10 can accurately perform reception processing on the data of the bit rate A2 for each bit (i.e., at the clock A2). The OLT 3 manages the transmission timing (access timing) of the upstream data of each ONU 2, and thus recognizes the reception timing of data of the bit rates A1 and A2 without performing detection and establishment processing of upstream frame synchronization.

As described above, in accordance with the ON/FF state of the M divider circuit 9, the data processor 10 performs reception processing on the data of the bit rate A1 at the clock A1 or the data of the bit rate A2 at the clock A2.

With the configuration of the OLT 3, in accordance with the frame format shown in Fig. 2, the OLT 3 can transmit data addressed to the ONU-ai at the bit rate A1 and can transmit data addressed to the ONU-bj at the bit rate A2. Further, with respect to upstream frames from the ONUs 2 in which data of the bit rate A1 and the data of the bit rate A2 are mixed, the common bit-synchronization processor 8 establishes bit synchronization at the clock A2, and the timing controller 34 controls the ON/OFF state of the M divider circuit 9. With this arrangement, data with the first bit rate A1 can be subjected to reception processing at the clock A1 (M bit cycle), which is obtained by frequency-dividing the clock A2 by M, and the high-speed data of the bit rate A2 can be subjected to the reception processing at a bit unit cycle by using the clock A2.

As shown in Fig. 3, the framing processor 4 in the OLT 3 includes a data reception buffer 41, header adding units 42a and 42b, a coupling unit 43, a PCBd #1 adding unit 44a, a PCBd #2 adding unit 44b, a BIP calculating unit 45, a BIP insertion buffer 46, a BIP adding unit 47, and a synchronization-bit processing/scrambling unit 48, in order to generate a frame signal as described above and shown in Fig. 2.

The data reception buffer 41 receives, from a high-order system connected to the OLT 3, data to be transmitted from the OLT 3 to the ONU 2, and temporarily stores the received data. The data reception buffer 41 then transmits the data as a group of signals for each specified ONU 2. In this case, the data reception buffer 41 may have a buffer for data of the first bit rate "2.5 Gb/s" and a buffer for data of the second bit rate of 10 Gb/s. This arrangement allows a writing operation and a reading operation to be performed independently from each other.

The header adding unit 42a adds header information, which contains management information such as destination and bit rate information, to predetermined-length data that have the first bit rate of 2.5 Gb/s and that are output from the data reception buffer 41. For example, by adding 5-byte header information to data that have a data length of 48 bytes and that are output from the data reception buffer 41, the header adding unit 42a can generate a data packet according to an ATM (asynchronous transfer mode) format.

The header adding unit 42b adds 2.5 Gb/s (the first bit rate) header information, which contains management information such as destination and bit rate information, to predetermined-length data that have a bit rate of 10 Gb/s that are output from the data reception buffer 41. Thus, the header adding units 42a and 42b constitute a header-information adding unit, which adds header information for the first bit rate to data having the first bit rate and the second bit rate.

Since both of the header information inserted by the header adding unit 42a and 42b have the first bit rate, each ONU 2 can identify whether or not each data signal is addressed to the ONU 2 by referring to the header information corresponding the data signals, regardless of the bit rate used for data-signal reception.

Through time-division multiplexing, the coupling unit 43 couples data packets to which the header information is added as described above, to thereby make it possible to generate the payload field 720 in the frame signal shown in Fig. 2. In addition, the PCBd #1 adding unit 44a and the PCBd #2 adding unit 44b respectively add contents to be written to the PCBd #1 field 711 and the PCBd #2 field 713 (see Fig. 15), which serve as frame headers, to the beginning portion of signals in which the payload field 720 was generated by the coupling unit 43.

Thus, the coupling unit 43, the PCBd #1 adding unit 44a, and the PCBd #2 adding unit 44b constitute a frame-signal generating unit, which generates a data string by time-division-multiplexing the header-information-added data signals and also adds a frame header to the data string.

The BIP calculating unit 45 serves as a party determining unit for determining parities of frame signals sequentially generated by the coupling unit 43, the PCBd #1 adding unit 44a, and the PCBd #2 adding unit 44b. In the first embodiment, the BIP calculating unit 45 determines BIP values (in parity bits) of fields divided for each bit rate.

More specifically, the BIP calculating unit 45 includes a low-speed BIP calculating unit 45a for calculating BIPs of fields having a bit rate of 2.5 Gb/s in frame signals, a high-speed BIP calculating unit 45b for calculating BIPs for fields having a bit rate of 10 Gb/s, and a BIP calculating buffer 45c for buffering the values of the PCBd #2 field 713 inserted into a frame signal that precedes a frame signal to be calculated by the low-speed BIP calculating unit 45a.

Thus, as shown in [1] in Fig. 2, the low-speed BIP calculating unit 45a extracts, from the BIP calculating buffer 45c, information in the PCBd #2 field 713 inserted into the preceding frame signal; extracts information in a section having the first bit rate A1 from information in the payload field 720 in the preceding frame signal output from the PCBd #2 adding unit 44b and information in the PCBd #1 field 711 located at the beginning of the subsequent frame signal; and performs parity calculation corresponding to the information (i.e., the bit value) of the first bit rate A1, based on the extracted information.

As shown in [1] in Fig. 2, out of information in the payload field 720 of the preceding frame signal output from the PCBd #2 adding unit 44b, the high-speed BIP calculating unit 45b extracts information in a section having the second bit rate A2 "10 Gb/s", and then performs parity calculation corresponding to the information (the bit value) of the bit rate A2 "10 Gb/s" based on the extracted information.

As described above, when the coupling unit 43 in the framing processor 4 generates a data string through time-division multiplexing, the timing controller 34 manages the arrangement timing of data signals and corresponding individual header information. Upon receiving the information regarding the arrangement timing from the timing controller 34, the low-speed BIP calculating unit 45a and the high-speed BIP calculating unit 45b can also extract information corresponding to a signal of each bit rate to perform parity calculation.

In addition, by reading the information that is related to the bit rate of each data signal and that is contained in the individual header information added to the data signal, the low-speed BIP calculating unit 45a and the high-speed BIP calculating unit 45b can also extract information corresponding to a signal of each bit rate to perform parity calculation.

The BIP insertion buffer 46 performs timing adjustment of the frame signal to which the frame header was added by the PCBd #2 adding unit 44b, in order for the BIP adding unit 47 at the subsequent stage to insert parity (BIP) bits into the BIP field 712. For example, through buffering, the BIP insertion buffer 46 delays information contained in an area subsequent to the BIP field 712 in the frame signal to reserve the BIP field 712. The BIP adding unit 47 then writes (adds or inserts) parity bits, resulting from the parity calculation performed by the low-speed BIP calculating unit 45a and the high-speed BIP calculating unit 45b, to the BIP field 712.

Thus, the BIP insertion buffer 46 and the BIP adding unit 47 constitute a parity-bit inserting unit. That is, based on the result of the parity calculation performed by the low-speed BIP calculating unit 45a and the high-speed BIP calculating unit 45b, the BIP insertion buffer 46 and the BIP adding unit 47 insert parity bits corresponding to the first bit rate A1 and the second bit rate A2 to the frame signal as parity bits for parity checking to be performed by the ONUs 2-1 to 2-N.

The synchronization-bit processing/scrambling unit 48 receives the frame signal to which the BIPs were added by the BIP adding unit 47, removes the bit value of the synchronization signal (PSync) contained in the PCBd #1 field 711 in the frame signal, and performs scrambling processing. With respect to the signal resulting from the scrambling processing, after the bit value of the original synchronization information is returned to the beginning portion of the frame signal, the signal is output to the E/O converter 5 as a downstream signal for transmission.

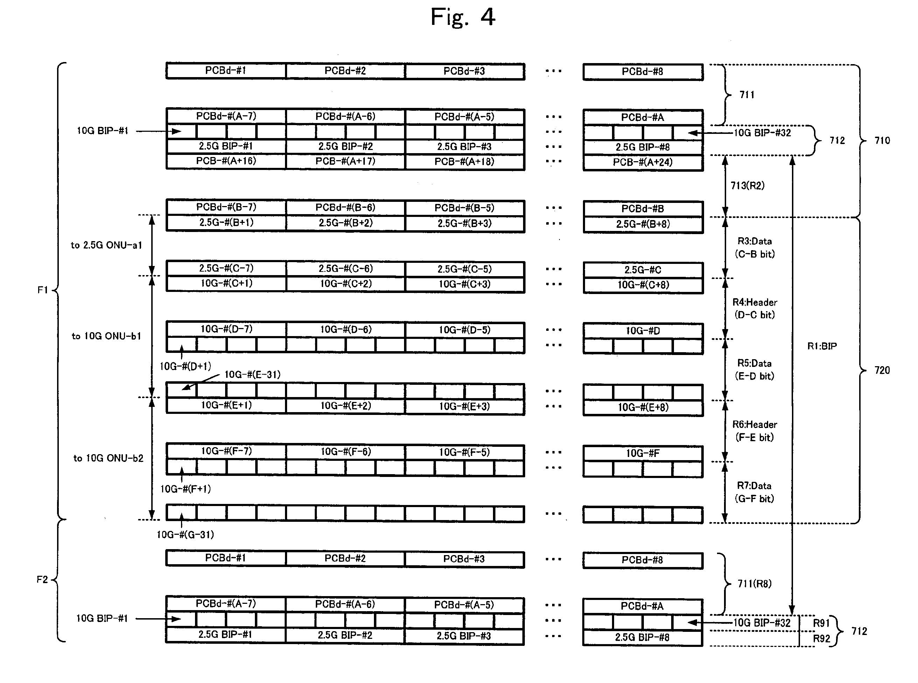

Fig. 4 shows one example of a scheme for parity calculation performed by the BIP calculating unit 45. In the example shown in Fig. 4, it is assumed that frame signals F1 and F2 are sequentially input and bits are vertically arranged in each row (in the horizontal direction) for every eight bits at a bit length of 2.5 Gb/s. In this case, parity calculation is performed on bit values in each column (in the vertical direction) in an area (a BIP calculation area: R1) located between preceding and subsequent BIP areas 712, for each value of low-speed 2.5 Gb/s bits and high-speed 10 Gb/s bits.

Fig. 4 also shows an example of frame signals in which data packets addressed to one low-speed ONU-a (the first subscriber device) for transmitting/receiving data signals of the first bit rate A1 and data packets addressed to two high-speed ONU-b1 and ONU-b2 for transmitting/receiving data signals with of second bit rate A2 are time-division multiplexed in the payload field 720.

More specifically, the low-speed BIP calculating unit 45a extracts, from the BIP calculating buffer 45c, the bit values of the PCBd #2 field 713 in the preceding frame signal F1, and also extracts, from the PCBd #2 adding unit 44b, the bit values of the payload field 720 in the preceding frame F1 and the PCBd #1 field 711 in the current frame F2 subsequent to the preceding frame F1. The low-speed BIP calculating unit 45a then arranges the extracted bit values, for example, at a bit length of 2.5 Gb/s in 8-bit columns, as shown in Fig. 4, and performs parity calculation for each column. The number of arranged bit columns is merely one example, and another number of bit columns may be arranged to perform parity calculation.

In this case, during generation of a data string through time-division multiplexing, the timing controller 34 manages the timing of arranging data signals and corresponding individual header information. This makes it possible to recognize to which fields in a frame signal the bit values input to the low-speed BIP calculating unit 45a and the high-speed BIP calculating unit 45b belong.

Thus, under the control of the timing controller 34, the low-speed BIP calculating unit 45a extracts bit values in a row having a bit length of 2.5 Gb/s from the 8-bit columns arranged as described above, and performs parity calculation on the extracted bit values for each column.

In this case, the low-speed BIP calculating unit 45a calculates a total of bit values for each of the 8 bit columns arranged as described above, with respect to the bit values (PCBd # (A+16) to PCBd #B in an area R2 shown in Fig. 4) of the PCBd #2 field 713 in the preceding frame signal F1 from the BIP calculating buffer 45c, the bit values (Data (C-B bits) in an area R3) of 2.5 Gb/s packet data (a header and data signals) contained in the payload field 720 in the preceding frame signal F1, the bit values (a header (D-C bits) in an area R4 and a header (F-E bits) in an area R6) of the header field in 10 Gb/s packet data, and the bit values (PCBd-#1 to PCBd-#A in an area R8) of the PCBd #1 field 711 in the current frame signal F2.

Thereafter, parity bit values corresponding to the results of the parity calculation for the respective columns, the parity calculation being performed by the low-speed BIP calculating unit 45a, are determined as parity bits for corresponding portions (2.5 G BIP-#1 to 2.5 G BIP-#8 in the area R92) in the BIP field 712. That is, when the total of the bit values indicates that the number of bit values (logic level) "1" for a corresponding column is an even number, the parity bit of the column is set to logic level "0", and when the total of the bit values indicates that the number of bit values "1" is an odd number, the parity bit of the column is set to "1". The BIP adding unit 47 adds (inserts) the parity bit, determined as described above by the low-speed BIP calculating unit 45a, to the BIP field 712.

For example, in Fig. 4, bits PCBd-#(A+16) and PCBd-#(B-7) in the area R2, bits 2.5G-# (B+1) and 2.5G-#(C-7) in the area R3, and bits PCBd-#1 and PCBd-#(A-7) in the area R8 are arranged at the leftmost side in the 8 bit columns. In this case, the low-speed BIP calculating unit 45a calculates a total of the bit values (i.e., performs parity calculation), and the BIP adding unit 47 adds a parity bit, determined as described above in accordance with the result of the parity calculation, to a corresponding position (2.5 G BIP-#1 in the area R92) in the low-speed BIP field 712.

Under the control of the timing controller 34, the high-speed BIP calculating unit 45b extracts the bit values of the 10 Gb/s data areas R5 and R7 (10G-# (D+1) to 10G-#E and 10G-# (F+1) to 10G-#G) from the payload field 720 in the preceding frame F1 and performs parity calculation.

In this case, arrangement of bits for every 32 bits at a bit length of 10 Gb/s per row in the calculation area R1 provides an arrangement in 32 columns in a 10 Gb/s bit section. The high-speed BIP calculating unit 45b performs parity calculation for each column in accordance with the arrangement. The number of arranged bit columns is merely one example, and another number of bit columns may be arranged to perform parity calculation.

In this case, since the bit length of 10 Gb/s is one fourth of the bit length of 2.5 Gb/s, arrangement of bits for every 8 bits at a bit length of 2.5 Gb/s provides an arrangement in rows for every 32 bits in a 10 Gb/s bit section. Thus, the high-speed BIP calculating unit 45b calculates a parity for each 32-bit column mentioned above, and similarly to the low-speed BIPs, the BIP adding unit 47 adds parity bits to corresponding positions (10G BIP-#1 to 10G BIP-#32 in the area R91), based on the result of the parity calculation. Under the timing control of the timing controller 34, the BIP adding unit 47 sequentially adds BIP, based on the results of the parity calculation performed by the low-speed BIP calculating unit 45a and the high-speed BIP calculating unit 45b.

As described above, the BIP calculating unit 45 performs parity calculation corresponding to each bit rate of a data signal and sets the BIP field 712 (R91 and R92 shown in Fig. 4) corresponding to each bit rate. As a result, it is possible to add a BIP corresponding to each bit rate to a frame signal.

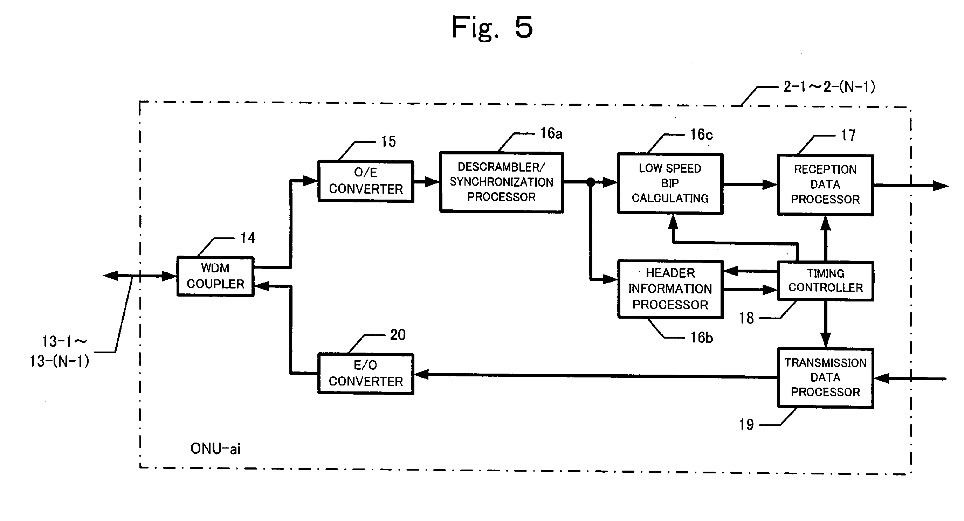

The ONUs 2 (e.g., the ONUs 2-1 to 2-(N-1)) for which the first bit rate A1 is set for receiving data signals from the OLT 3 have the configuration of the ONU-ai shown in Fig. 5, and the ONUs 2 (e.g., the ONU 2-N) for which the communication bit rate (the second bit rate) that is M times the first bit rate A1 (e.g., M=4) is set have the configuration of the ONU-bj shown in Fig. 6.

As shown in Fig. 5, the low-speed ONU-ai (see reference numerals 2-1 to 2-(N-1) shown in Fig. 1) includes a WDM coupler 14, an O/E converter 15, a descrambler/synchronization processor 16a, a header-information processor 16b, a low-speed BIP calculating unit 16c, a reception-data processor 17, a timing controller 18, a transmission-data processor 19, and an E/O converter 20. The low-speed ONU-ai operates (i.e., performs reception processing) by using the clock A1 corresponding to the first bit rate A1 as a basic operation clock.

In the low-speed ONU-ai shown in Fig. 5, the WDM coupler 14 branches a downstream optical frame signal (light in a 1.49 µm band), input from the optical fiber 13, to the O/E converter 15, and also transmits an upstream optical signal (light in a 1.31 µm band), input from the E/O converter 20, to the optical fiber 13. The O/E converter 15 opto-electrically converts the downstream frame, branched by the WDM coupler 14, from optical signals into analog electrical signals. Further, the O/E converter 15 outputs the converted analog electrical signals as digital electrical signals whose "1s" or "0s" are identified, in synchronization with a clock cycle of 2.5 Gb/s.

The descrambler/synchronization processor 16a identifies the synchronization bit PSync in the downstream frame signal converted into the digital electrical signals by the O/E converter 15, i.e., detects a frame synchronization, and performs descrambling processing. In the descrambling processing, the descrambler/synchronization processor 16a performs descrambling after removing the synchronization bit PSync in the frame signal, then adds the synchronization bit PSync to its original position again, and outputs the resulting frame signal.

Thus, the WDM coupler 14 and the O/E converter 15 constitute a frame receiving unit for receiving the frame signal.

The header-information processor 16b reads the header information, added by the header adding units 42a and 42b in the OLT 3, from the frame signal descrambled by the descrambler/synchronization processor 16a, to thereby obtain the information of in-frame-signal position of a packet data to which the header information is added and information regarding the destination and bit rate of a data signal subsequent to the read header information. The header-information processor 16b can output the obtained information to the timing controller 18 at the subsequent stage.

Thus, the header-information processor 16b and the timing controller 18 constitute a timing-information obtaining unit. That is, in response to a reception frame signal received by the descrambler/synchronization processor 16a serving as the frame receiving unit, the header-information processor 16b and the timing controller 18 obtain timing information indicating timing at which each data signal of the first bit rate A1 is time-division multiplexed in the reception frame signal, by referring to the first-bit-rate-A1 header information added to the data signal time-division multiplexed in the frame signal.

Further, under the timing control of the timing controller 18, the low-speed BIP calculating unit 16c performs parity checking on the frame signal descrambled by the descrambler/synchronization processor 16a, through parity calculation similar to that performed by the low-speed BIP calculating unit 45a in the OLT 3. For example, when the total number of bit values "1" in each column in areas R2 to R4, R6, and R8 in which 2.5 Gb/s bits are arranged in the BIP calculation area R1 shown in Fig. 4 and the BIP area R92 is an even number, the low-speed BIP calculating unit 16c outputs a check result indicting that the parity check is OK, whereas, when the number of bit values "1" is an odd number, the low-speed BIP calculating unit 16c outputs a check result indicating that the parity check failed. In this case, when all the parity-check results of the columns are OK, the low-speed calculating unit 16c can output information indicating that the parity checking is successful.

Thus, the low-speed calculating unit 16c serves as a parity checking unit, which performs parity checking on bit values of the first bit rate A1 in the reception frame signal, based on the timing information obtained by the header-information processor 16b included in the timing-information obtaining unit.

As described above, under the control of the timing controller 18, the reception-data processor 17 performs reception processing on data signals addressed to the local ONU, with respect to the frame signals subjected to the parity checking by the BIP calculating unit 16c. The transmission-data processor 19 performs transmission processing for a transmission signal at timing for code-division multiple access, the ONU-ai being notified of the timing under the control of the timing controller 18.

The timing controller 18 performs timing control for each function unit in the ONU-ai, based on the management information obtained by the header-information processor 16b, the management information including information regarding the in-frame position of a data signal multiplexed in a frame signal, a destination, and a bit rate. For example, the timing controller 18 controls reception timing for the reception processing performed by the reception-data processor 17 and also performs timing control for the BIP calculation performed by the low-speed calculating unit 16c so as to correspond to position of data addressed to the ONU-ai.

The E/O converter 20 electro-optically converts the upstream data, input from the transmission-data processor 19, from electrical signals to optical signals (e.g., light in a 1.31 µm band for upstream transmission). The upstream data may also have the first bit rate A1.

On the other hand, as shown in Fig. 6, the high-speed ONU-bj (see the ONU 2-N shown in Fig. 1) includes a WDM coupler 21, an O/E converter 22, a reception-data processor 25, a timing controller 26, a transmission-data processor 27, and an E/O converter 28 (which correspond to the units 14, 15, 17, 18, 19, and 20, respectively, shown in Fig. 5), and further includes a PSync removing unit 23a, a high-speed descrambler 23b, a high-speed BIP calculating unit 23c, a divider circuit 23d, a low-speed descrambler 23e, and a header-information processor 23h.

The O/E converter 22 in the ONU-bj shown in Fig. 6 opto-electrically converts downstream optical signals (e.g., light in a 1.49 µm band), transmitted through the optical fiber 13, from optical signals to analog electrical signals, and the converted electrical signals whose "1s" or "0s" are further identified in synchronization with a clock cycle of 10 Gb/s.

The PSync removing unit 23a identifies a synchronization bit PSync having a bit length of 2.5 Gb/s in the downstream frame signal converted into the electrical signals by the O/E converter 22 (i.e., detects a frame synchronization), removes the identified synchronization bit PSync, and outputs the resulting frame signal.

Thus, the WDM coupler 21 and the O/E converter 22 constitute a frame receiving unit for receiving the frame signal.

The high-speed descrambler 23b receives, from the PSync removing unit 23a, the frame signal from which the synchronization bit PSync was removed, and performs descrambling processing corresponding to a bit rate of 10 Gb/s.

Further, under the timing control of the timing controller 26, the BIP calculating unit 23c performs parity checking on the frame signal descrambled by the high-speed descrambler 23b, through parity calculation similar to that performed by the high-speed BIP calculating unit 45b in the OLT 3. For example, when the total number of bit values "1" in each column in areas R5 and R7 in which 10 Gb/s bits are arranged in the BIP calculation area R1 shown in Fig. 4 and the BIP area R91 is an even number, the BIP calculating unit 23c outputs a check result indicting that the parity check is OK, whereas, when the number of bit values "1" is an odd number, the BIP calculating unit 16c outputs a check result indicating that the parity check failed. In this case, when all the parity-check results of the columns are OK, the high-speed BIP calculating unit 23c can output information indicating that the parity checking is successful.

Thus, the BIP calculating unit 23c serves as a parity checking unit, which performs parity checking by using parity bits that are used for parity checking to be performed by the second subscriber device and that are inserted into the reception frame signal output from the PSync removing unit 23a, based on the timing information obtained by the header-information processor 23h included in a timing-information obtaining unit.

The divider circuit 23d divides the frequency of the frame signal, from which the synchronization bit PSync was removed by the PSync removing unit 23a, by M (= 4 in this case), and outputs the resulting signal having a bit length of 2.5 Gb/s. In the areas in which 2.5 Gb/s bits are arranged in the frame signal, as a result of the conversion processing performed by the O/E converter 22, a digital electrical signal containing a series of M same codes (M=4) is output for each 2.5 Gb/s unit bit, and as a result of the frequency-division processing performed by the divider circuit 23d, the signal can be converted into a signal having its original bit length "2.5 Gb/s".

As a result of the frequency division performed by the divider circuit 23d, with respect to bit values in a frame signal, 2.5 Gb/s bit values divided (in a series of the same codes) at the bit length of 20 Gb/s by the O/E converter 22 are output as having its original bit length "2.5 Gb/s", whereas 10 Gb/s bit values are output as having codes extracted every other four bits and having a bit length of 2.5 Gb/s.

The low-speed descrambler 23e further performs descrambling processing corresponding to a bit rate of 2.5 Gb/s on the frame signal converted by the divider circuit 23d into a bit rate of 2.5 Gb/s.

The header-information processor 23h reads, from the frame signal subjected to the descrambling processing as described above, the header information (for the first bit rate of 2.5 Gb/s) added by the header adding units 42a and 42b in the OLT 3, and obtains the information regarding the destination and the bit rate of a data signal subsequent to the read header information.

Based on the information regarding the destination and the bit rate of the data signal multiplexed in the frame signal, the information being obtained by the header-information processor 23h, the timing controller 26 controls reception timing for reception processing to be performed by the reception-data processor 25 and also controls timing for BIP calculation to be performed by the high-speed BIP calculating unit 23c, so as to correspond to the data position of the ONU 2-N.

Thus, the divider circuit 23d, the low-speed descrambler 23e, the header-information processor 23h, and the timing controller 26 constitute a timing-information obtaining unit, which obtains the information of timing at which the data signals of the second bit rate A2 are time-division multiplexed in the frame signal, by referring to the base-bit rate-A1 header information added to the reception frame signal input from the PSync removing unit 23a included in the frame receiving unit.

Under the control of the timing controller 26, the reception-data processor 25 performs reception processing on data signals (10 Gb/s) transmitted to the ONU 2-N, with respect to the frame signal subjected to the parity checking by the high-speed BIP calculating unit 23c. Under the control of the timing controller 26, the transmission-data processor 27 performs transmission processing on signals (having, e.g., a bit rate of 10 Gb/s, similarly to the downstream data) to be transmitted to the OLT 3, at timing used for time-division multiple access and specified by the ONU 2-N.

The E/O converter 28 electro-optically converts the upstream data, input from the transmission-data processor 27, from electrical signals into optical signals (light in a 1.31 µm band for upstream transmission).

In the PON system 1 configured as described above, the header adding units 42a and 42b in the framing processor 4 in the OLT 3 add header information for the first bit rate A1 to data signals having the first bit rate A1 and data signals having the second bit rate A2, and the coupling unit 43, the PCBd #1 adding unit 44a, and the PCBd #2 adding unit 44b perform time-division multiplexing on the header-information-added data signals to generate a data string and also adds a frame header to the data string to generate a frame signal. Further, the BIP calculating unit 45 then determines parities of the sequentially-generated frame signals. Based on the result of the parity calculation, the BIP adding unit 47 inserts parity bits for parity checking to be performed by the first and second subscriber devices into the frame signals.

In this case, the BIP calculating unit 45 determines parities of the sequentially-generated frame signals so as to correspond to the bit values of the first bit rate A1 and the second bit rate A2. Based on the result of the parity calculation, the BIP calculating unit 45 inserts parity bits corresponding to the first bit rate A1 and parity bits for the second bit rate A2 to the frame signals as parity bits for parity checking to be performed by the low-speed ONU-ai (the first subscriber device) and the high-speed ONU-bj (the second subscriber device).

With respect to BIP calculation for performing reception processing on downstream frame signals, under the timing control of the timing controller 18, the BIP calculating unit 16c in the low-speed ONU-ai shown in Fig. 5 can perform parity checking for 2.5 Gb/s data signals, based on the values of the areas R2 to R4, R6, and R8 in which 2.5 Gb/s bits are arranged and the 2.5 Gb/s BIP area R92. Thus, even when data signals having a bit rate of 10 Gb/s are mixed, there is no problem with the BIP calculation.

On the other hand, with respect to BIP calculation for performing reception processing on downstream frame signals, under the timing control of the timing controller 26, the BIP calculating unit 23c in the high-speed ONU-bj shown in Fig. 6 can perform parity checking for 10 Gb/s data signals, based on the values of the areas R5 and R7 in which 10 Gb/s bits are arranged and the 10 Gb/s BIP area R91.

In the low-speed ONU-ai, addition of only the functions of the BIP calculating unit 16c and the timing controller 18 can achieve parity checking corresponding to BIPs contained in a frame signal in the first embodiment. This arrangement can eliminate a need for making substantial changes to the specification of hardware. Thus, only making changes through firmware updating or the like can achieve the parity checking, and thus it is possible to minimize the amount of work required for upgrading the low-speed ONU-ai, compared to the configuration of the ONUs according to the known technology.

As described above, according to the first embodiment, the BIP calculating unit 45 and the BIP adding unit 47 can insert parity bits for parity checking to be performed by the ONU-bj (serving as the second subscriber device), together with the parity bits for parity checking to be performed by the ONU-ai (serving as the first subscriber device), to the frame signal. Thus, the second embodiment has some advantages. That is, when data having mixed bit rates are to be transmitted, BIP calculation can be easily performed while maintaining compatibility with an existing system and reducing cost and work required for upgrading the optical subscriber devices.

### B) Second Embodiment

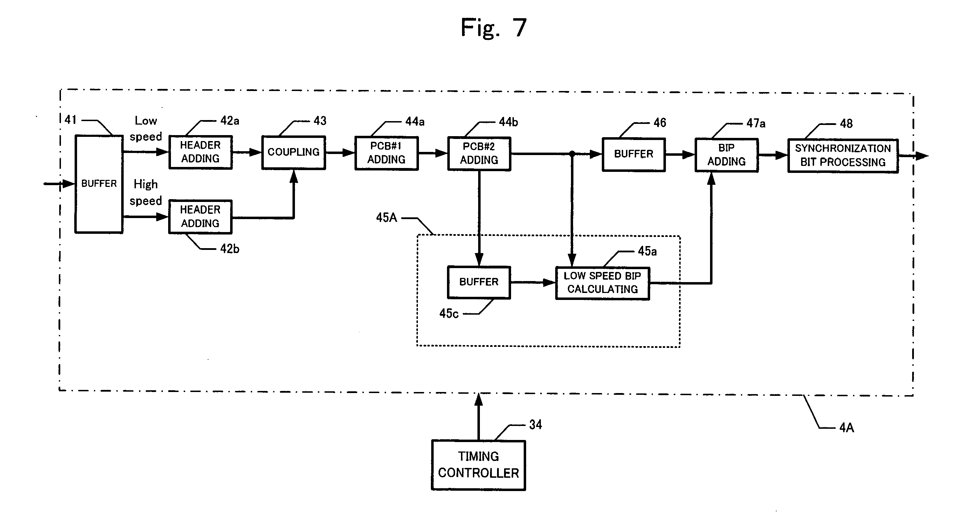

Fig. 7 shows the configuration of a major section of an OLT 3 used for a PON system (a bit-rate-mixed optical communication system) according to a second embodiment. The PON system in the second embodiment has substantially the same configuration as the PON system 1 shown in Fig. 1, but is different therefrom in the format of BIPs inserted for parity checking to be performed by an ONU-bj (see reference numeral 2-N) for receiving data having a bit rate of 10 Gb/s and in a configuration for parity checking to be performed by the ONU-bj.

Thus, the OLT 3 in the second embodiment is different from the one in the first embodiment in that a framing processor 4A having a BIP calculating unit 45A different from the one shown in Fig. 3 is provided. The configuration of the framing processor 4A shown in Fig. 7, other than the BIP calculating unit 45A and a BIP adding unit 47A, has substantially the same configuration as that shown in Fig. 3, and, in Fig. 7, the same reference numerals as those in Fig. 3 indicate substantially the same units.

The BIP calculating unit 45A (which serves as a parity determining unit) includes a low-speed BIP calculating unit 45a and a BIP calculating buffer 45c, which are similar to those described in the first embodiment. Thus, the BIP calculating unit 45A determines, as common BIPs used for the ONU-ai and ONU-bj for transmitting/receiving data signals of the first bit rate A1 and the second bit rate A2, parities of sequentially generated frame signals so as to correspond to bit values for the first bit rate A1.

Thus, since data signals included in frame signals and transmitted to the high-speed ONU 2-N (see Fig. 1) have header information of the first bit rate A1, the Low-speed BIP calculating unit 45a does not calculate parities for 10 Gb/s data signals based on the data signals, and performs parity calculation including the header information of the first bit rate A1, the header information being to be received by the high-speed ONU 2-N together with the data signals.

Such a parity calculation of the bit values for the first bit rate A1 is also performed on bit values including bit values to be received by the high-speed ONU 2-N, and can be used for, at least, detecting communication error between the OLT 3 and the ONU 2-N.

Based on the result of the parity calculation performed by the Low-speed BIP calculating unit 45A, the BIP adding unit 47A that constitutes a parity-bit inserting unit together with a BIT insertion buffer 46 inserts, as parity bits of the first bit rate A1 and the second bit rate A2, common parity bits to a frame signal as parity bits for parity checking to be performed by the ONUs 2-1 to 2-(N-1) serving as the first subscriber devices and by the ONU 2-N serving as the second subscriber device.

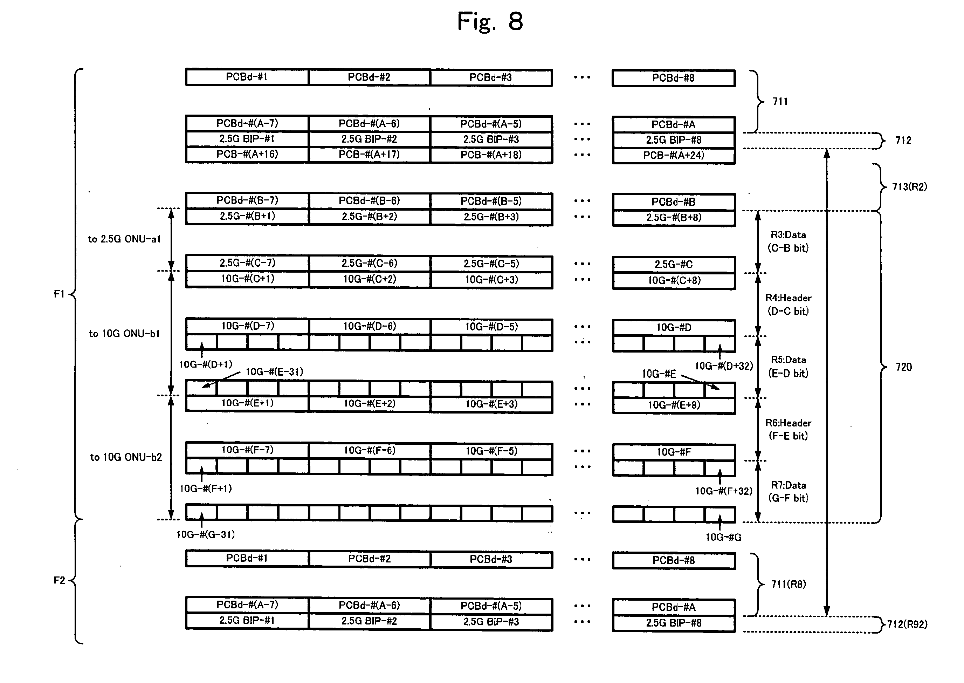

Fig. 8 illustrates one example of the scheme for parity calculation performed by the BIP adding unit 47A included in the framing processor 4A in the second embodiment. As shown in Fig. 8, the low-speed BIP calculating unit 45a extracts, from the BIP calculating buffer 45c, bit values of a PCBd #2 field 713 in a preceding frame signal F1, and also extracts, from a PCBd #2 adding unit 44b, bit values of a payload field 720 in the preceding frame and a PCBd #1 field 711 in a current frame F2 that follows the preceding frame F1.

For example, as shown in Fig. 8, the extracted bit values are vertically arranged at a bit length of 2.5 Gb/s with a length corresponding to eight bits in the horizontal direction, and parity calculation is performed on each 8-bit column. The number of arranged bit columns is merely one example, and another number of bit columns may be arranged to perform parity calculation.

The bit adding unit 47A adds, as common parity bits for the low-speed ONU-ai and the high-speed ONU-bj, parity bit values corresponding to the results of the parity calculation for the respective columns which was performed by the low-speed BIP calculating unit 45a to corresponding positions (2.5 G BIP #1 to 2.5 G BIP-#8 in an area R92) in a BIP area 712 in the frame signal F2.

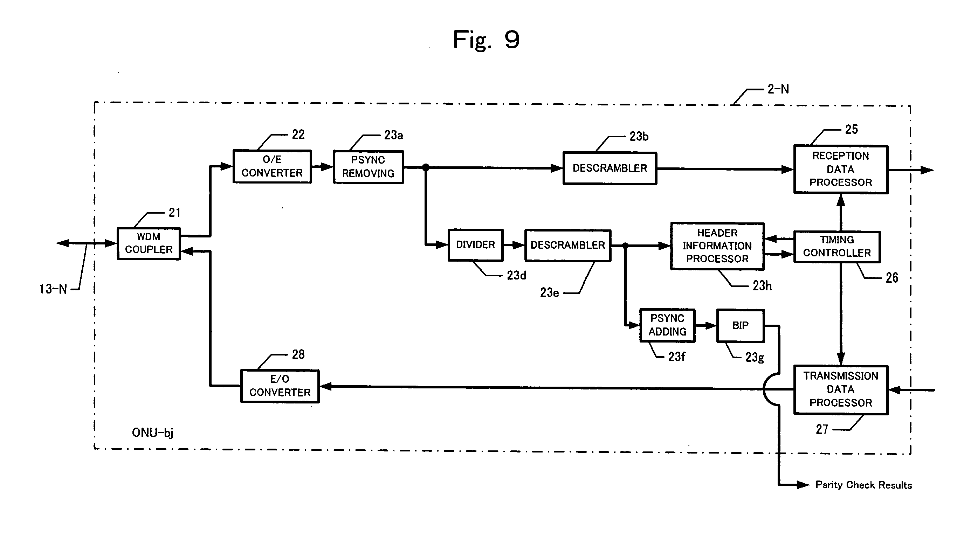

With regard to the ONUs 2 (see Fig. 1) included in the PON system 1 according to the second embodiment, the low-speed ONU-ai (see reference numerals 2-1 to 2-(N-1)) has a similar configuration to that described above and shown in Fig. 5 and can perform parity checking using parity bits written to the area R92 shown in Fig. 8. On the other hand, the high-speed ONU-bj has a structure as shown in Fig. 9 to perform parity checking using common parity bits, as described above.

The high-speed ONU-bj shown in Fig. 9 is different from the one described in the first embodiment (see Fig. 6) in that the BIP calculating unit 23c is not interposed between the descrambler 23b and the reception-data processor 25 and a PSync adding unit 23f and a low-speed BIP calculating unit 23g are provided. Other configurations are substantially the same as those shown in Fig. 6. In Fig. 9, the same reference numerals for the units in the ONU-bj as those used in Fig. 6 indicate substantially the same units.

The PSync adding unit 23f returns a synchronization bit PSync to a signal subjected to descrambling processing by the descrambler 23e, with respect to a signal frequency-divided by the divider circuit 23d. The low-speed BIP calculating unit 23g performs parity checking on the frame signal to which the synchronization bit PSync was returned by the PSync adding unit 23f, through parity calculation that is similar to that performed by the low-speed BIP calculating unit 16c (see Fig. 5) included in each of the ONUs 2-1 to 2-(N-1).

Thus, for example, as shown in Fig. 8, the low-speed BIP calculating unit 23g calculates a total of bit values for each of the arranged 8-bit columns, with respect to the bit values (PCBd #(A+16) to PCBd #B in the area R2 shown in Fig. 8) of the PCBd #2 field 713 in the preceding frame signal F1 from the BIP calculating buffer 45c, the bit values (Data (C-B bits) in an area R3) of 2.5 Gb/s packet data (a header and data signals) contained in the payload field 720 in the preceding frame signal F1, the bit values (a header (D-C bits) in an area R4 and a header (F-E bits) in an area R6) of the header field in 10 Gb/s packet data, the bit values (PCBd-#1 to PCBd-#A in an area R8) of a PCBd #1 field 711 in the current frame signal F2, and the bit values of the BIP field 712.

As a result, when the total number of bit values "1" in each column is an even number, a check result indicting that the parity check is OK is output, whereas, when the number of bit values "1" is an odd number, a check result indicating that the parity check failed is output. In this case, when all the parity-check results of the columns are OK, information indicating that the parity checking is successful can be output.

Thus, the low-speed calculating unit 23g serves as a parity checking unit. That is, based on the timing information obtained by the header-information processor 23h included in a timing-information obtaining unit, the low-speed calculating unit 23g performs parity checking on bit values of the first bit rate in a reception frame signal by using parity bits for parity checking for bit values of the first bit rate A1.

As described above, according to the second embodiment, the BIP calculating unit 45A and the BIP adding unit 47A can insert common parity bits for parity checking to be performed by the ONU-ai (serving as the first subscriber device) and the ONU-bj (serving as the second subscriber device) to the frame signal. Thus, the second embodiment has some advantages. That is, when data having mixed bit rates are to be transmitted, BIP calculation can be easily performed while maintaining compatibility with an existing system and reducing cost and work required for upgrading the optical subscriber devices.

### C) Third Embodiment

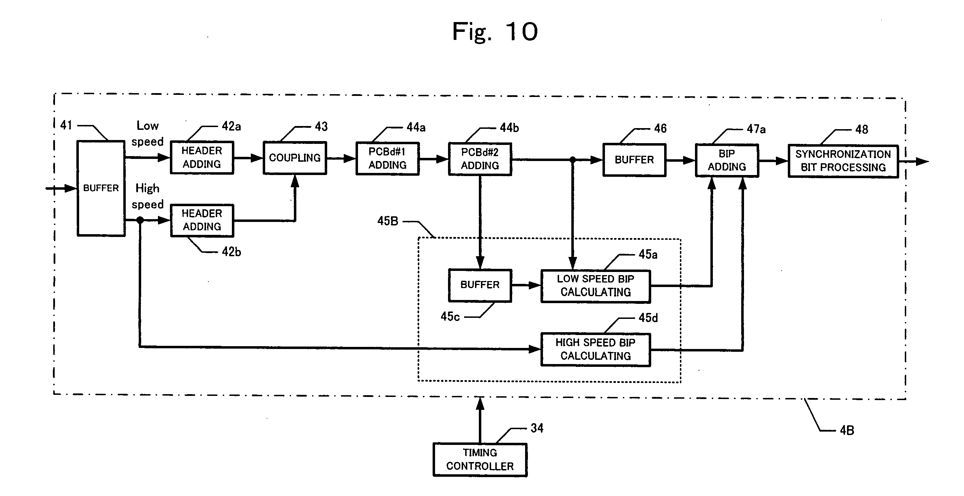

Fig. 10 shows the configuration of a major section of an OLT 3 used for a PON system according to a third embodiment. The PON system in the third embodiment also has substantially the same configuration as the PON system 1 of the first embodiment, but is different therefrom in the format of BIPs inserted for parity checking to be performed by an ONU-bj (see reference numeral 2-N) for receiving data having a bit rate of 10 Gb/s and in a configuration for parity checking to be performed by the ONU-bj.

Thus, the OLT 3 in the third embodiment is different from the one according to the first embodiment shown in Fig. 3 in that a framing processor 4B having a BIP calculating unit 45B and a BIP adding unit 47B is provided. Except for the BIP calculating unit 45B and the BIP adding unit 47B, the configuration of the framing processor 4B shown in Fig. 10 has substantially the same configuration as that shown in Fig. 3, and, in Fig. 10, the same reference numerals as those in Fig. 3 indicate substantially the same units.

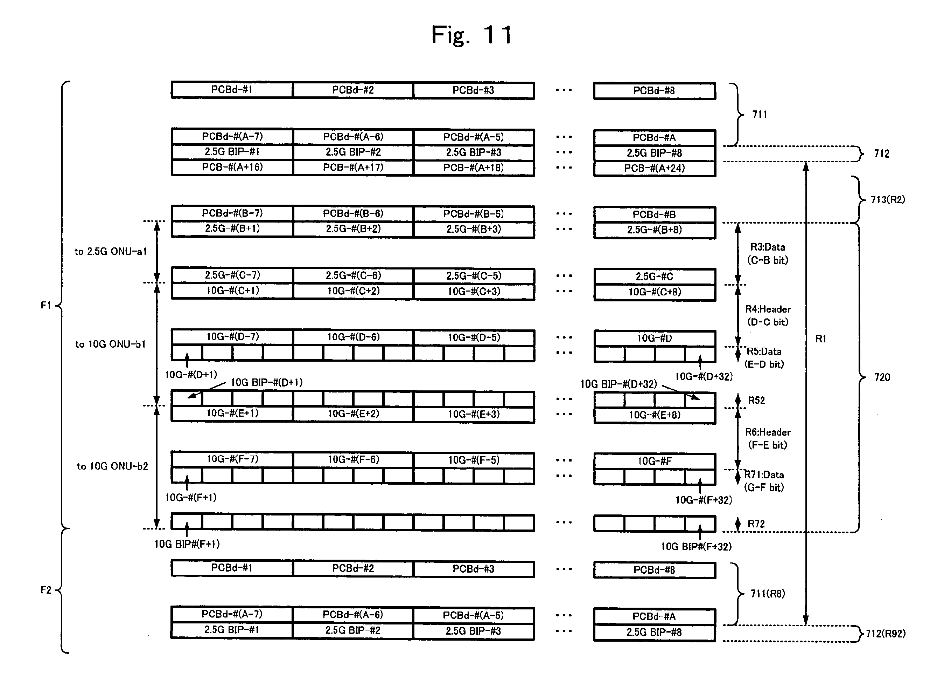

The BIP calculating unit 45B (which serves as a parity determining unit) determines parities of sequentially generated frame signals so as to correspond to the bit values of the first bit rate A1 and the bit values of data signals of the second bit rate A2 included in a data string (a payload area 720 described below and shown in Fig. 11). Specifically, the BIP calculating unit 45B includes a low-speed BIP calculating unit 45a and a BIP calculating buffer 45c, which are similar to those described in the first embodiment, in order to determine BIPs used for parity checking to be performed by the low-speed ONU-ai, and also includes a high-speed BIP calculating unit 45d for determining BIPs used for parity checking to be performed by the high-speed ONU-bj.

The high-speed BIP calculating unit 45d individually determines parity bits corresponding to the bit value of each data signal of the bit rate A2. More specifically, the high-speed calculating unit 45d extracts data signals of the bit rate A2 from data signals output from the buffer 41 and addressed to respective destinations, and performs parity calculation on the extracted data signals for the destination.

Further, the BIP adding unit 47B inserts, as parity bits for parity checking to be performed by the ONU-bj corresponding to the destination of the data signals, parity bits corresponding to the bit values of data signals determined by the high-speed calculating unit 45d into a continuous area in the data signals.

Fig. 11 shows a scheme for parity bit determining for the high-speed calculating unit 45d and a scheme for BIP adding for the BIP adding unit 47B. As shown in the example of Fig. 11, with respect to frame signals F1 and F2 that are sequentially input, bits are arranged in each row, for example, for every eight bits at a bit length of 2.5 Gb/s. In this case, parity calculation is performed on bit values in each column in an area (a BIP calculation area: R1) located between preceding and subsequent BIP areas 712, for each value of low-speed 2.5 Gb/s bits and high-speed 10 Gb/s bits.

More specifically, as in the case of the first embodiment, the low-speed BIP calculating unit 45a extracts, from the BIP calculating buffer 45c, the bit values of the PCBd #2 field 713 in the preceding frame signal F1, and also extracts, from the PCBd #2 adding unit 44b, the bit values of a payload field 720 in the preceding frame F1 and a PCBd #1 field 711 in the current frame F2 subsequent to the preceding frame F1. The low-speed BIP calculating unit 45a then arranges the extracted bit values, for example, at a bit length of 2.5 Gb/s in the horizontal direction (in the row direction) with a bit length corresponding to 8 bits, for example, as shown in Fig. 11, and performs parity calculation for each column.

Thereafter, the BIP adding unit 47B adds parity bit values corresponding to the results of the parity calculation for the respective columns which was performed by the low-speed BIP calculating unit 45a to corresponding portions (2.5 G BIP-#1 to 2.5 G BIP-#8 in an area R92) in the BIP field 712. That is, when the total of the bit values indicates that the number of bit values "1" for a corresponding column is an even number, the parity bit of the column is set to "0", and when the total of the bit values indicates that the number of bit values "1" is an odd number, the parity bit of the column is set to "1".

The high-speed BIP calculating unit 45d extracts, from the buffer 41, data signals having the bit rate A2 (10 Gb/s) which correspond to the destination, and performs parities of the data signals. In the case of the frame structure shown in Fig. 11, the high-speed BIP calculating unit 45d extracts data signals corresponding to a data area R51 (10G-# (D+1) to 10G-# (D+32)) and a data area R71 (10G-# (F+1) to 10G-# (F+32)). Then, the high-speed BIP calculating unit performs parity calculation on the extracted data signals. As in the case of the first embodiment, under the control of the timing controller 34, the high-speed BIP calculating unit 45d may extracts bit values of the data areas R51 and R71 from the frame signal from the PCBd #2 adding unit 44b.

In this case, during the parity calculation, it is assumed in Fig. 11 that 32-bit bit values are arranged, as information in the data areas R51 and R7, in each row at a bit length of 10 Gb/s. The high-speed BIP calculating unit 45d performs parity calculation for each column in each of the areas R51 and R71 according to the arrangement.

For example, in a section in which the bit values (10G-#(D+1) to 10G-#(D+32)) in the area R51 are "1", "1" is given as a BIP value for a corresponding column in the subsequent area R52 (10 G BIP-# (D+1) to 10 G BIP-# (D+32)), whereas "0" is given as a BIP value for a section in which the bit values are "0".

Similarly, in a section in which the bit values (10G-#(F+1) to 10G-#(F+32)) in the area R71 are "1", "1" is given as a BIP value for a corresponding column in the subsequent area R72 (10 G BIP-# (F+1) to 10 G BIP-# (F+32)), whereas "0" is given as a BIP value for a section in which the bit values are "0".

In this manner, the BIP calculating unit 45 performs parity calculation for each bit rate of data signals and sets BIP areas (R52 and R72 in Fig. 11) corresponding to each bit rate. As a result, it is possible to add BIPs corresponding to each bit rate to a frame signal. The number of bit columns used for the parity calculation is one example, and another number of columns may be arranged to perform the parity calculation.

The ONU 2 that receives a frame signal into which the BIP was inserted, as described above, may basically have the same configuration as that described in the above first embodiment. That is, the use of the configuration shown in Fig. 5 allows the ONU-ai that receives data signals of the first bit rate rate A1 "2.5 Gb/s" to perform parity checking, and on the other hand, the use of the configuration shown in Fig. 6 allows the ONU-bj that receives data signals of the second bit rate A2 "10 Gb/s" to perform parity checking.

In this case, as shown in Fig. 6, under the timing control of the timing controller 26, the BIP calculating unit 23c in the ONU-bj performs parity checking on the frame signal descrambled by the high-speed descrambler 23b, through parity calculation similar to that performed by the high-speed BIP calculating unit 45b in the OLT 3. For example, with respect to the frame signal from the high-speed descrambler 23b, when the total number of bit values "1" in each column in the areas R51 (or R71) in which 10 Gb/s bits are arranged in shown in Fig. 11 and the subsequent BIP area R52 (R72) is an even number, a check result indicting that the parity check is OK is output, whereas, when the number of bit values "1" is an odd number, a check result indicating that the parity check failed is output.

In this case, when a plurality of multiplexed 10 Gb/s data signals exist, it can be determined that no reception error is occurring when the parity check result of data signals transmitted to the local ONU is OK. Further, performing similar parity checking on data signals addressed to another ONU makes it possible to monitor the state of the communication lines in the entire PON system 1. In this case, when all parity check results are OK, information indicating that the parity checking is successful can be output.

As described above, according to the third embodiment, the BIP calculating unit 45B and the BIP adding unit 47B can insert parity bits for parity checking to be performed by the ONU-bj (serving as the second subscriber device), together with parity bits for parity checking to be performed by the ONU-ai (serving as the first subscriber device), to the frame signal. Thus, as in the first embodiment, the third embodiment has some advantages. That is, when data having mixed bit rates are to be transmitted, BIP calculation can be easily performed while maintaining compatibility with an existing system and reducing cost and work required for upgrading the optical subscriber devices.

### D) Other Embodiments

The present invention is not limited to the above-described embodiments, and various changes and modifications can be made thereto without departing from the spirit and scope of the present invention.

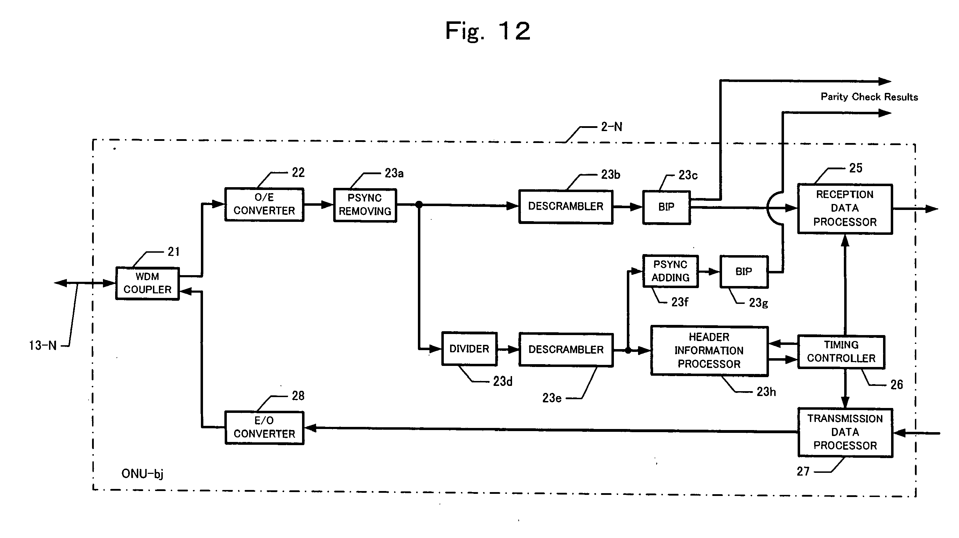

For example, as shown in Fig. 12, the ONU-bj (see Fig. 6) in the first or third embodiment which receives a data signal of the second bit rate may further have the configuration for parity checking in the second embodiment (i.e., the PSync adding unit 23f and the BIP calculating unit 23g shown in Fig. 9). Such an arrangement allows parity checking to be performed for all areas in a received frame signal, and thus provides an advantage in that the communication-line states of all reception data can be monitored.

In this case, when both results of the parity checking performed by the high-speed BIP calculating unit 23c and the BIP calculating unit 23g are successful, the ONU may output a message indicating the success of the parity checking. The PSync adding unit 23f and the BIP calculating unit 16c may be eliminated as needed.

Data-signal bit rates mixed in a frame signal transmitted from the OLT are not limited to those two bit rates in the above-described embodiments, and may be three bit rates if the value thereof is a natural-number multiple of the first (basic) bit rate.

Although cases in which the first bit rate is 2.5 Gb/s have been described in the above embodiments, the first bit rate may have another value.

It is apparent to those skilled in the art that the apparatus and devices according to the present invention are manufactured in accordance with the disclosure of the above-described embodiments.

## Claims

1. A communication apparatus for performing optical communication with a first terminal device communicating at a first bit rate, and a second terminal device communicating at a second bit rate being a multiple of the first bit rate, via an optical splitting device, the communication apparatus comprising:
a transmission-data processing unit for processing a bit rate of data signals transmitted to the second terminal device so as to be a multiple of the bit rate of data signals transmitted to the first terminal device, the data signals being contained in a frame signal transmitted from the communication apparatus; and
a parity-bit inserting unit for inserting, into the frame signal, each parity-bits for parity checking for the data signals transmitted to the first terminal device, and the second terminal device respectively.

2. The communication apparatus according to claim 1,
wherein the parity-bit inserting unit is adapted to insert, into the frame signal, the parity-bits of the first bit rate as each parity bits for parity checking for the data signals transmitted to the first terminal device and the second terminal device respectively.

3. The communication apparatus according to claim 1 or 2, the second terminal device comprising:
a frame receiving unit for receiving the frame signal; and
a parity checking unit for parity checking for the data signals having the second bit rate or, if the parity bits of the first bit rate are inserted, for parity checking for the data signals having the having the first bit rate, the data signals being contained in the frame signal output by the frame receiving unit.

4. A parity-bit inserting method for a station-side apparatus in an optical communication system including the station-side apparatus transmitting a frame signal comprised data having a first bit rate and data having a second bit rate being a multiple of the first bit rate; at least one first subscriber device receiving the data having the first bit rate; at least one second subscriber device receiving the data having the second bit rate; and transmission path splitting the frame signal transmitted from the station-side apparatus and connecting the split frame signal to the first and second subscriber devices, the parity-bit inserting method for the station-side apparatus comprising the steps of:
adding header information of the first bit rate to the data having the first bit rate and the data having the second bit rate;
generating a data signal string multiplexed in time division on data signals added the header information, and generating a frame signal added a frame header to the data signal string;
determining parities of the frame signal; and
inserting parity bits for parity checking for the data signals of the first bit rate and the data signals of the second bit rate into the frame signal, based on the parity calculation.

5. The parity-bit inserting method according to claim 4, the parity-bit inserting method comprising the steps of:
determining parities of the frame signal so as to correspond to data signals for the first bit rate and the second bit rate respectively; and
inserting parity bits corresponding to the first bit rate and the second bit rate respectively into the frame signal, based on the parity calculation.

6. The parity-bit inserting method according to claim 5, the parity-bit inserting method comprising the steps of:
determining arrangement timing of the data and the header information corresponding to the data, for generating the data signal string; and
determining parities of the frame signal, corresponding to the data signals of each bit rate, based on the arrangement timing.

7. The parity-bit inserting method according to claim 5, the parity-bit inserting method comprising the steps of:
adding information regarding the bit rate of the data and information regarding the arrangement timing of the data signals into the header information in the frame signal; and
determining parities of the frame signal, corresponding to the data signals of each bit rate, based on the information regarding the arrangement timing.

8. The parity-bit inserting method according to claim 4, the parity-bit inserting method comprising the steps of:
determining parities of the frame signal so as to correspond to data signals for the first bit rate; and
inserting common parity bits into the frame signal as parity bits for the data signals of the first bit rate and parity bits for the data signals of the second bit rate, based on the parity calculation.

9. The parity-bit inserting method according to claim 8, the parity-bit inserting method comprising the steps of:
determining arrangement timing of the data and the header information corresponding to the data, for generating the data signal string; and
determining parities of the frame signal, corresponding to the data signals of the first bit rate, based on the arrangement timing.

10. The parity-bit inserting method according to claim 4, the parity-bit inserting method comprising the steps of:
determining parities of the frame signal so as to correspond to bit column of data signals for the first bit rate and the second bit rate respectively; and
inserting parity bits corresponding to the first bit rate into the frame signal as parity bits for parity checking to be performed by the first subscriber device and inserting parity bits corresponding to the bit column of data signals of the second bit rate into a continuous area to the data signals, based on the parity calculation.

11. A parity checking method for a subscriber device receiving a frame signal into which the parity bits are inserted by the parity-bit inserting method according to claim 5, the frame signal being transmitted from the station-side apparatus, the parity checking method comprising the steps of:
wherein the frame signal includes the data signal added the header information having information regarding the arrangement timing of the data signal;
the first subscriber device performing the parity checking on bit for the first bit rate in the frame signal, based on the parity bits inserted so as to correspond to the first bit rate; and
the second subscriber device detecting the arrangement timing of the data signals of the second bit rate in the frame signal, from the header information of the data signals, and performing parity checking on the bit for the second bit rate, based on the parity bits inserted so as to correspond to the second bit rate.

12. A parity checking method for a subscriber device receiving a frame signal into which the parity bits are inserted by the parity-bit inserting method according to claim 8, the frame signal being transmitted from the station-side apparatus, the parity checking method comprising the steps of:
each of the first and second subscriber devices performing parity checking on the bit for the first bit rate, based on the inserted common parity bits.

13. A parity checking method for a subscriber device receiving a frame signal into which the parity bits are inserted by the parity-bit inserting method according to claim 10, the frame signal being transmitted from the station-side apparatus, the parity checking method comprising the steps of:
wherein the frame signal includes the data signal added the header information having information regarding the arrangement timing of the data signal;
the first subscriber device performing parity checking on the bit for the first bit rate in the frame signal, based on the parity bits inserted so as to correspond to the first bit rate; and
the second subscriber device detecting the arrangement position of the data signals of the second bit rate in the frame signal, from the header information of the data signals, and performing parity checking on the bit for the second bit rate, based on the data signals addressed to the second subscriber device and parity bits sequentially inserted into the data signals.

14. The parity checking method according to claim 11,
wherein the second subscriber device performs parity checking on the bit for the first bit rate, based on the parity bits inserted so as to corresponding to the first bit rate.

15. A station-side apparatus in an optical communication system including the station-side apparatus transmitting a frame signal comprised data having a first bit rate and data having a second bit rate being a multiple of the first bit rate; at least one first subscriber device receiving the data having the first bit rate; at least one second subscriber device receiving the data having the second bit rate; and transmission path splitting the frame signal transmitted from the station-side apparatus and connecting the split frame signal to the first and second subscriber devices, the station-side apparatus comprising:
a header-information adding unit for adding header information of the first bit rate to the data having the first bit rate and the data having the second bit rate;
a frame-signal generating unit for generating a data signal string multiplexed in time division on data signals added the header information, and generating a frame signal added a frame header to the data signal string;
a parity determining unit for determining parities of the frame signal; and
a parity-bit inserting unit for inserting parity bits for parity checking for the data signals of the first bit rate and the data signals of the second bit rate into the frame signal, based on the parity calculation performed by the parity determining unit.

16. The station-side apparatus according to claim 15,
wherein the parity determining unit is adapted to determine the parities of the frame signal so as to correspond to data signals for the first bit rate and the second bit rate respectively, and the parity-bit inserting unit is adapted to insert parity bits corresponding to the first bit rate and the second bit rate respectively into the frame signal, based on the parity calculation.

17. The station-side apparatus according to claim 15,
wherein the parity determining unit is adapted to determine the parities of the frame signal so as to correspond to data signals for the first bit rate, and the parity-bit inserting unit is adapted to insert common parity bits into the frame signal as parity bits for the data signals of the first bit rate and parity bits for the data signals of the second bit rate, based on the parity calculation.

18. The station-side apparatus according to claim 15,
wherein the parity determining unit is adapted to determine determining parities of the frame signal so as to correspond to a bit column of data signals for the first bit rate and the second bit rate respectively, and the parity-bit inserting unit is adapted to insert parity bits corresponding to the first bit rate into the frame signal as parity bits for parity checking to be performed by the first subscriber device and inserts parity bits corresponding to the bit column of data signals of the second bit rate into a continuous area to the data signals, based on the parity calculation.

19. A subscriber device receiving a frame signal transmitted from the station-side apparatus according to claim 15, the subscriber device comprising:
a frame receiving unit for receiving the frame signal;
a timing-information obtaining unit for obtaining timing information indicating timing at which data signals of the first bit rate are time-division multiplexed in the frame signal received by the frame receiving unit, by referring to the header information for the first bit rate, the header information being added to the data signals time-division multiplexed in the received frame signal; and
a parity checking unit for performing parity checking on the bit of the first bit rate in the frame signal, based on the timing information obtained by the timing-information obtaining unit, by using parity bits for parity checking for the first bit rate.
